# EUROPEAN PATENT SPECIFICATION

(11) **EP 4 091 745 B1**
(45) Date of publication and mention of the grant of the patent: **10.07.2024**
(21) Application number: 20932082.9
(22) Date of filing: 24.04.2020
(51) Int. Cl.: C04B 41/00, C04B 41/50, C04B 41/52, C04B 41/85, C04B 41/89, C23C 14/02, C23C 14/06, C23C 14/32, C23C 28/04, C23C 30/00, H01J 37/32

(54) **CUTTING TOOL**
SCHNEIDWERKZEUG
OUTIL DE COUPE

(43) Date of publication of application: 23.11.2022
(73) Proprietor: Sumitomo Electric Hardmetal Corp., Itami-shi, Hyogo 664-0016 (JP)
(72) Inventor: TABAYASHI, Daiji, Itami-shi, Hyogo 664-0016 (JP); FUKUI, Haruyo, Itami-shi, Hyogo 664-0016 (JP); UTSUMI, Yoshiharu, Kyoto-shi, Kyoto 601-8205 (JP); TAKAMATSU, Hajime, Kyoto-shi, Kyoto 601-8205 (JP)
(74) Representative: Boult Wade Tennant LLP
(86) International application number: PCT/JP2020/017714
(87) International publication number: WO 2021/214985

(56) References cited:
- WO-A1-2017/022659
- JP-A- 2003 062 705
- JP-A- 2009 220 238
- JP-A- 2009 220 238
- JP-A- 2009 241 252
- JP-A- 2017 171 988

## Description

### TECHNICAL FIELD

The present invention relates to a cutting tool.

### BACKGROUND ART

Hard carbon films such as amorphous carbon and diamond-like carbon are used as coating materials for cutting tools, metal molds, and machine components because of their excellent wear resistance and lubricity.

Japanese Patent Laying-Open No. 2003-62706 (PTL 1) discloses an amorphous carbon covered tool comprising a base body composed of WC base and an amorphous carbon film that covers the base body.

WO 2016/190443 (PTL 2) discloses a cutting tool equipped with a base body and a DLC layer positioned on the surface of the base body and containing diamond-like carbon. JP 2009 220238 A (PTL 3) relates to an amorphous carbon coated tool.

### CITATION LIST

### PATENT LITERATURE

PTL 1: Japanese Patent Laying-Open No. 2003-62706
PTL 2: WO 2016/190443
PTL 3: JP 2009 220238 A

### SUMMARY OF INVENTION

A cutting tool of the present invention is according to claim 1.

### BRIEF DESCRIPTION OF DRAWINGS

Fig. 1 is a cross-sectional view of an example of a cutting tool according to one embodiment of the present invention.
Fig. 2 is a cross-sectional view of another example of a cutting tool according to one embodiment of the present invention.
Fig. 3 is an image showing the results of observation on the cross section of the hard carbon film of a cutting tool according to one embodiment of the present invention, using a high angle annular dark field scanning transmission electron microscope.
Fig. 4 is an image showing the results of observation on the cross section of the hard carbon film of a conventional cutting tool, using a high angle annular dark field scanning transmission electron microscope.
Fig. 5 is a diagram for describing the method for measuring black regions of the hard carbon film.
Fig. 6 is a schematic diagram showing an example of a film forming apparatus used in the production of a cutting tool according to one embodiment of the present invention.
Fig. 7 shows an example of a target used in the production of a cutting tool according to one embodiment of the present invention.

### DETAILED DESCRIPTION

### [Problem to be Solved by the Present Invention]

In recent years, the diversity of work materials has advanced, and processing of soft metals such as aluminum alloys, non-ferrous metals such as titanium, magnesium, and copper, organic materials, materials containing hard particles such as graphite, and carbon fiber reinforced plastics (CFRPs) has been carried out.

When cutting the above materials using a cutting tool having a hard carbon film, the work material tends to adhere to the cutting edge portion of the tool, causing increased cutting resistance, edge defects, and a decreased tool life. This is especially likely to occur when the work material is a soft metal. Accordingly, there is a need for a cutting tool that can have a long tool life even when used to cut soft metals.

Therefore, an object of the present invention is to provide a cutting tool that can have a long tool life even when used to cut soft metals in particular.

### [Advantageous Effect of the Present Invention]

According to the present invention, it is possible to provide a cutting tool that can have a long tool life even when used to cut soft metals in particular.

### [Description of Embodiments]

At first, implementations of the present invention are described.

A cutting tool of the present invention is according to claim 1.

The cutting tool of the present invention can have a long tool life even when used to cut soft metals in particular.

The hard carbon film preferably has a thickness of 0.1 µm or more and 3 µm or less at a portion involved in cutting. According to this, exfoliations or defects of the hard carbon film can be suppressed.

The base body and the hard carbon film are preferably in contact with each other. According to this, the adhesiveness between the base body and the hard carbon film is improved.

The cutting tool preferably comprises an interface layer disposed between the base body and the hard carbon film,
wherein the interface layer contains:
   · at least one selected from the group consisting of a material made of a single element selected from a first group consisting of Group 4 elements, Group 5 elements, Group 6 elements, Group 13 elements, and Group 14 elements excluding carbon in the Periodic Table, an alloy or first compound containing at least one element selected from the first group, and a solid solution derived from the first compound; or
   · one or both of a second compound composed of at least one element selected from the first group and carbon, and a solid solution derived from the second compound, and
the interface layer has a thickness of 0.5 nm or more and less than 10 nm.

According to this, the base body and the hard carbon film are firmly adhered to each other via the interface layer, and the interface layer acts to balance the difference in hardness between the base body and the hard carbon film, in other words, it acts as a buffer, which improves impact resistance as well.

The base body is preferably composed of WC-based cemented carbide or cermet. According to this, the cutting tool is suited for cutting non-ferrous alloys, especially aluminum alloys, copper alloys, magnesium alloys, and others.

The base body is preferably composed of cubic boron nitride. According to this, the cutting tool is suited for cutting non-ferrous alloys, especially aluminum alloys, copper alloys, magnesium alloys, and others.

### [Details of Embodiments of the Present Invention]

Hereinafter, a specific example of the cutting tool of the present invention will be described with reference to drawings. In the drawings of the present invention, the same reference signs represent the same portions or equivalent portions. In addition, dimensional relationships such as length, width, thickness, and depth are changed as appropriate for clarity and simplicity in the drawings and do not necessarily represent actual dimensional relationships.

Notations in the form of "A to B" as used herein mean the upper limit and lower limit of the range (that is, A or more and B or less), and when no unit is given in A but only in B, the unit in A is the same as the unit in B.

### [Embodiment 1: Cutting Tool]

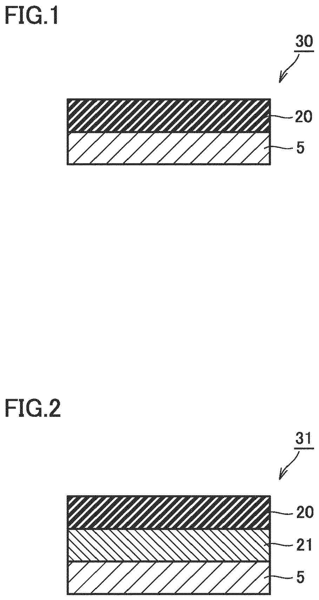

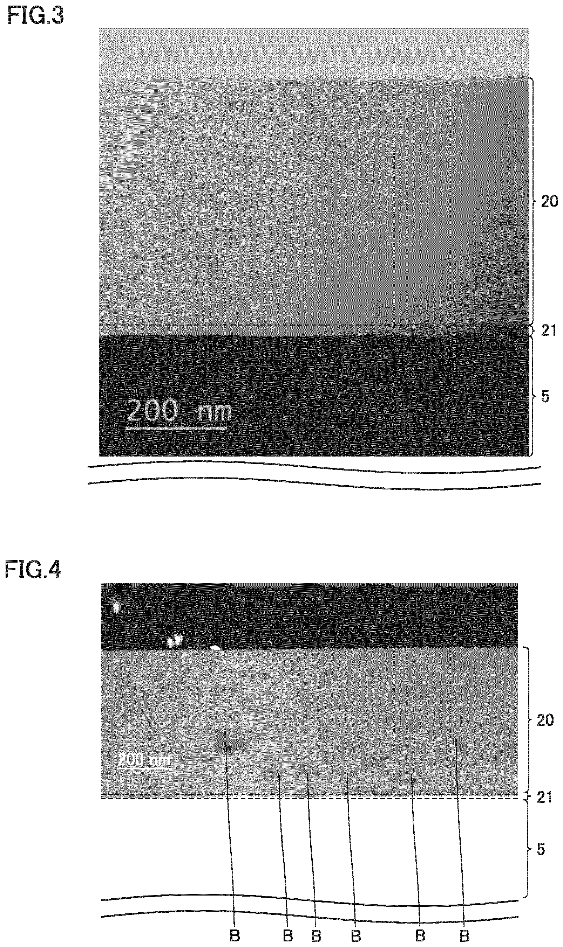

A cutting tool according to one embodiment of the present invention (hereinafter, also referred to as "the present embodiment") will be described with reference to Figs. 1 to 3. Fig. 1 is a cross-sectional view of an example of the cutting tool according to the present embodiment. Fig. 2 is a cross-sectional view of another example of the cutting tool according to the present embodiment. Fig. 3 is an image showing the results of observation on the cross section of the hard carbon film of a cutting tool according to one embodiment of the present invention, using a high angle annular dark field scanning transmission electron microscope (hereinafter, also referred to as "HADDF-STEM").

As shown in Fig. 1, a cutting tool 30 of the present embodiment comprises a base body 5 and a hard carbon film 20 arranged on the base body 5, in which, when the cross section of the hard carbon film is observed using a high angle annular dark field scanning transmission electron microscope, the area proportion of black regions with an equivalent circle diameter of 10 nm or more is 0.7% or less, and the hard carbon film has a hydrogen content of 5 atom% or less.

The cutting tool of the present embodiment can have a long tool life even when used to cut soft metals in particular. The reason for this is not clear, but may be presumed to be as in (i) and (ii) below.
(i) As for the cutting tool of the present embodiment, when the cross section of its hard carbon film is observed using a HADDF-STEM, the area proportion of black regions with an equivalent circle diameter of 10 nm or more is 0.7% or less. The black regions with an equivalent circle diameter of 10 nm or more in the hard carbon film is thought to originate from defects of the film, such as macroparticles and voids present in the film, as well as abnormal growth portions of the film. Accordingly, it is thought that the amount of defects in the hard carbon film of the cutting tool of the present embodiment is reduced to 0.7% or less on an area basis.

When cutting soft metals such as aluminum alloys using a cutting tool having a film on the surface thereof, the work material is repeatedly deposited on and removed from the film surface. When the deposited work material is removed from the film, stress in the direction of tearing off the film and stress in the shear direction, which is approximately parallel to the film surface, are considered to be exerted on the film. At this time, if defects are present in the film, the defects are considered to be the starting point for destruction of the film, resulting in an advance in damage to the film.

Since the amount of defects in the hard carbon film is reduced in the cutting tool of the present embodiment, destruction originating from defects is unlikely to occur. Accordingly, the cutting tool of the present embodiment can have a long tool life even when used to cut soft metals in particular.

(ii) In the cutting tool of the present embodiment, the hard carbon film has a hydrogen content of 5 atom% or less. According to this, the proportion of sp3 bonds in the hard carbon film is higher, resulting in higher hardness. Furthermore, the oxidation resistance of the hard carbon film is also improved. Accordingly, the cutting tool of the present embodiment can have a long tool life.

In Fig. 1, base body 5 and hard carbon film 20 are in contact with each other, but the cutting tool of the present embodiment is not limited to this. For example, as shown in Fig. 2, a cutting tool 31 of the present embodiment can comprise an interface layer 21 disposed between base body 5 and hard carbon film 20. It can also comprise, between base body 5 and interface layer 21, a mixed composition layer (not shown in the figure) in which the compositions of these films are mixed, or a gradient composition layer (not shown in the figure) in which the composition varies continuously. Furthermore, it can comprise an underlying layer (not shown in the figure) between base body 5 and interface layer 21 for improving the adhesiveness between them.

Hard carbon film 20 may be arranged so as to cover the entire surface of base body 5, or it may be arranged so as to cover part of it. When the hard carbon film is arranged so as to cover part of the base body, it is preferably arranged so as to cover at least the surface of a portion of the base body involved in cutting. The portion of the base body involved in cutting as used herein means a region in the base body bounded by its cutting edge ridge and a hypothetical plane at a distance of 2 mm from the cutting edge ridge to the base body side along the perpendicular line of the tangent line of the cutting edge ridge.

### <Base Body>

As base body 5, metallic or ceramic base bodies can be used. Specific examples thereof include base bodies made of iron, heat-treated steel, WC-based cemented carbide, cermet, stainless steel, nickel, copper, aluminum alloys, titanium alloys, alumina, cubic boron nitride, and silicon carbide. Among them, it is preferable to use a base body composed of WC-based cemented carbide, cermet, or cubic boron nitride.

### <Hard Carbon Film>

### (Composition)

In the present specification, the term "hard carbon film" means what is commonly referred to by names such as diamond-like carbon (DLC), amorphous carbon, and diamond-like carbon. The hard carbon film contains carbon as its main component, and is structurally classified as amorphous rather than crystalline. It is thought to contain a mixture of single bonds (C-C), as seen in diamond crystal, and double bonds (C=C), as seen in graphite crystal, and depending on the production method, it may contain hydrogen, such as C-H.

The hard carbon film containing carbon as its main component means that the carbon content of the hard carbon film is 95 atom% or more. The carbon content in the hard carbon film can be measured using an X-ray photoelectron spectrometer (XPS measurement apparatus: "PHI 5000 VersaProbe III" (TM) manufactured by ULVAC-PHI, Inc.). Specifically, the sample surface is irradiated with X-rays and the kinetic energy of photoelectrons emitted from the sample surface is measured, thereby analyzing the composition of the elements constituting the sample surface. Note that, as far as the applicants performed measurements, even if the measurement results of the carbon content were calculated multiple times by changing the selected locations in the measurement field of view, there was almost no variation in the measurement results, and it was confirmed that the arbitrary setting of the measurement field of view did not result in arbitrary results as long as the measurements were performed on the same sample.

Whether the hard carbon film is amorphous can be confirmed by, for example, X-ray diffraction measurement. A specific confirmation method will be described below.

(A1) The hard carbon film formed on the substrate is subjected to X-ray diffraction measurement (measurement apparatus: "SmartLab" (TM) manufactured by Rigaku Corporation) under the conditions below to obtain an X-ray diffraction pattern.
X-ray source: Cu-kα radiation
X-ray output: 45 kV, 200 mA
Detector: one-dimensional semiconductor detector
Measurement range of diffraction angle 20: 15 to 140°
Scanning speed: 0.2°/min

(A2) When, in the obtained diffraction pattern, there are no peaks originating from graphite or diamond other than the peaks originating from the substrate, and a broad peak is observed, the hard carbon film is determined to be a non-crystalline phase.

### (Area Proportion of Black Regions)

As for hard carbon film 20, when its cross section is observed using a HADDF-STEM, the area proportion of black regions with an equivalent circle diameter of 10 nm or more (hereinafter, also referred to as "area proportion of black regions") is 0.7% or less.

When the area proportion of black regions is 0.7% or less, destruction of the hard carbon film is unlikely to occur and the tool life is improved. The upper limit of the area proportion of black regions is 0.7% or less, preferably 0.5% or less, more preferably 0.3% or less, and still more preferably 0.2% or less. The lower limit of the area proportion of black regions is 0% or more. The lower limit of the area proportion of black regions can be 0.05% or more from the viewpoint of production. The area proportion of black regions is 0% or more and 0.7% or less, preferably 0% or more and 0.5% or less, more preferably 0% or more and 0.3% or less, and still more preferably 0% or more and 0.2% or less.

The area proportion of black regions of the hard carbon film can be measured by observation with a HADDF-STEM. A specific measurement method will be described below.

(B1) By cutting the cutting tool along the normal direction of the surface, a sample including a cross section of the hard carbon film is fabricated. Ten arbitrary locations in the portion involved in cutting of the cutting tool are set as the cutting positions, and ten samples are fabricated. For the cutting, a focused ion beam apparatus, a cross section polisher apparatus, or the like is used.

(B2) The cross section of each sample is observed by the HAADF-STEM at a magnification of 200,000 times to obtain a dark field image.

(B3) In the obtained dark field image, the hard carbon film is identified. Energy dispersive X-ray analysis (EDX) associated with the HAADF-STEM is used to carry out mapping analysis of the cross section, enabling identification of the hard carbon film mainly composed of carbon, the interface layer, and the base body.

(B4) Within the hard carbon film region in the dark field image, a rectangular measurement field of view is set. A pair of opposite sides of the rectangle are parallel to the principal plane of the base body on the hard carbon film side and have a length of 800 nm. The distance between the side on the base body side among the opposite sides and the principal plane of the base body on the hard carbon film side is 30 nm. The distance between the side on the hard carbon film surface side among the opposite sides and the hard carbon film surface is 30 nm.

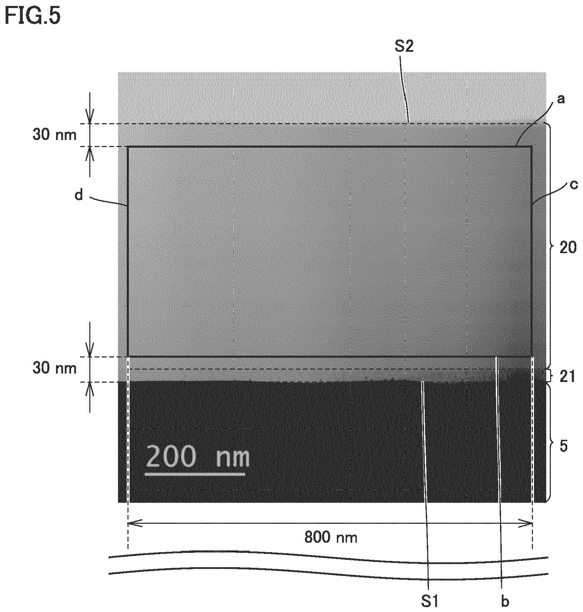

For the above measurement field of view, specific description will be given using Fig. 5. Fig. 5 is a dark field image obtained by observing a cross section of the cutting tool by a HAADF-STEM at a magnification of 200,000 times. In the dark field image, the region surrounded by a line segment a, a line segment b, a line segment c, and a line segment d corresponds to the rectangular measurement field of view. A pair of opposite sides (line segment a and line segment b) of the rectangle are parallel to a principal plane S1 of base body 5 on the hard carbon film side and have a length of 800 nm. The distance between the side (line segment b) on the base body side among the opposite sides, and principal plane S1 of base body 5 on the side of hard carbon film 20 is 30 nm. The distance between the side (line segment a) on the side of a surface S2 of hard carbon film 20 among the opposite sides, and surface S2 of hard carbon film 20 is 30 nm.

When the principal plane of base body 5 on the hard carbon film side has irregularities, principal plane S 1 of base body on the hard carbon film side is set as follows. In the measurement field of view, the portion of the base body with the greatest protrusion toward the hard carbon film side is identified. A line is drawn that passes through this portion and is parallel to the average line of the irregularities on the principal plane of the base body. This line is taken as principal plane S1 of the base body on the hard carbon side.

When the surface of hard carbon film 20 has irregularities, surface S2 of the hard carbon film is set as follows. In the measurement field of view, the portion on the surface of the hard carbon film with the greatest depression is identified. A line is drawn that passes through this portion and is parallel to the average line of the irregularities on the hard carbon film surface. This line is taken as surface S2 of the hard carbon film.

The reason for excluding the region in hard carbon film 20 where the distance from principal plane S1 of base body 5 is within 30 nm and the region in hard carbon film 20 where the distance from its surface S2 is within 30 nm in the setting of the measurement field of view is to exclude the influence of sample adjustment and the influence of the interface layer.

(B5) The dark field image is subjected to image processing using an image analysis software ("WinROOF" (TM) from Mitani Corporation) and is converted to a monochrome image with 256 gradations. At this time, the image that has been converted to a monochrome image with 256 gradations is adjusted so that there is no contrast difference in white regions within the measurement field of view.

(B6) In the above monochrome image, the average density within the above measurement field of view is determined. Using this average density as the threshold value, binarization processing is carried out on the monochrome image.

An example of an image of the cross section of the hard carbon film of the cutting tool of the present invention after binarization processing is shown in Fig. 3. As shown in Fig. 3, black regions are hardly observed in the hard carbon film of the cutting tool of the present invention.

An example of an image of the cross section of the hard carbon film of a conventional cutting tool after binarization processing is shown in Fig. 4. As shown in Fig. 4, in the hard carbon film of the conventional cutting tool, there are black regions indicated by a sign B.

(B7) The image after the binarization processing is subjected to particle analysis to determine the area of black regions with an equivalent circle diameter of 10 nm or more. The area proportion of black regions with an equivalent circle diameter of 10 nm or more with respect to the entire area of the measurement field of view is calculated.

(B8) For each of the ten samples, the area proportion of black regions is measured. The average value of the area proportions of black regions measured for the ten samples is taken as "the area proportion of black regions of the hard carbon film". Specifically, when the average value of the area proportions of black regions measured for the ten samples is 0.7% or less, it is confirmed that "the area proportion of black regions of the hard carbon film is 0.7% or less".

Note that, as far as the applicants performed measurements, even if the measurement results of the area proportion of black regions were calculated multiple times by changing the selected locations for the cutting plane or the selected locations in the measurement field of view, there was almost no variation in the measurement results, and it was confirmed that the arbitrary setting of the measurement field of view did not result in arbitrary results as long as the measurements were performed on the same sample.

### (Thickness)

Hard carbon film 20 preferably has a thickness of 0.1 µm or more and 3 µm or less at a portion involved in cutting (hereinafter, also referred to as "thickness of the hard carbon film"). The portion of the hard carbon film involved in cutting as used herein means a region in the hard carbon film bounded by the cutting edge ridge of the cutting tool and a hypothetical plane at a distance of 2 mm from the cutting edge ridge to the cutting tool side along the perpendicular line of the tangent line of the cutting edge ridge. The thickness of the portion of the hard carbon film involved in cutting means the thickness of the hard carbon film in the region of the hard carbon film involved in cutting, starting from its surface in the direction along the normal line of the surface.

When the thickness of the hard carbon film is 0.1 µm or more, wear resistance is improved. When the thickness of the hard carbon film is 3 µm or less, an increase in the internal stress accumulated inside the hard carbon film can be suppressed, and exfoliations or defects of the hard carbon film can be suppressed.

The lower limit of the thickness of the hard carbon film is preferably 0.1 µm or more, more preferably 0.5 µm or more, and still more preferably 1.0 µm or more. The upper limit of the thickness of the hard carbon film is preferably 3 µm or less, more preferably 2.0 µm or less, and still more preferably 1.5 µm or less. The thickness of the hard carbon film can be 0.1 µm or more and 3 µm or less, 0.5 µm or more and 2.0 µm or less, or 1.0 µm or more and 1.5 µm or less.

The thickness of the hard carbon film can be measured by observing the cross section of the hard carbon film using a SEM (scanning electron microscope, measurement apparatus: "JSM-6610 series" (TM) manufactured by JEOL Ltd.). Specifically, the observation magnification for the cross section sample is set to 5,000 to 10,000 times, the observation area is set to 100 to 500 µm², the thickness width is measured at three arbitrarily selected locations in one field of view, and their average value is used as the "thickness". Note that, as far as the applicants performed measurements, even if the thickness measurement results were calculated multiple times by changing the selected locations in the measurement field of view, there was almost no variation in the measurement results, and it was confirmed that the arbitrary setting of the measurement field of view did not result in arbitrary results as long as the measurements were performed on the same sample.

### (Hydrogen Content)

Hard carbon film 20 is basically composed of carbon and inevitable impurities, but may contain hydrogen. This hydrogen is thought to originate from residual hydrogen and moisture in the film forming apparatus that is incorporated into the hard carbon film during film formation.

Hard carbon film 20 has a hydrogen content of 5 atom% or less. According to this, the proportion of sp3 bonds in the hard carbon film is higher, resulting in higher hardness. Furthermore, the oxidation resistance of the hard carbon film is also improved. The upper limit of the hydrogen content of the hard carbon film is more preferably 4 atom% or less, and still more preferably 2 atom% or less. The lower limit of the hydrogen content of the hard carbon film is preferably 0 atom%, but from the viewpoint of production, it may be 0 atom% or more, 1 atom% or more, or 2 atom% or more. The hydrogen content of the hard carbon film can be 0 atom% or more and 5 atom% or less, 0 atom% or more and 4 atom% or less, 0 atom% or more and 2 atom% or less, 1 atom% or more and 5 atom% or less, 1 atom% or more and 4 atom% or less, 1 atom% or more and 2 atom% or less, 2 atom% or more and 5 atom% or less, or 2 atom% or more and 4 atom% or less.

The hydrogen content of the hard carbon film is measured using the ERDA (elastic recoil detection analysis, measurement apparatus: "HRBS500" manufactured by Kobe Steel, Ltd.). In this method, hydrogen ions colliding with He ions injected at a low angle of incidence are recoiled in the forward direction, and the energy of the recoiled hydrogen particles is analyzed to measure the amount of hydrogen. Note that, as far as the applicants performed measurements, even if the measurement results of the hydrogen content were calculated multiple times by changing the selected locations in the measurement field of view, there was almost no variation in the measurement results, and it was confirmed that the arbitrary setting of the measurement field of view did not result in arbitrary results as long as the measurements were performed on the same sample.

### (Hardness)

Hard carbon film 20 preferably has a hardness of 35 GPa or more and 75 GPa or less. When the hardness of the hard carbon film is 35 GPa or more, wear resistance is improved. When the hardness of the hard carbon film is 75 GPa or less, defect resistance is improved. The lower limit of the hardness of the hard carbon film is preferably 35 GPa or more, more preferably 45 GPa or more, and still more preferably 55 GPa or more. The upper limit of the hardness of the hard carbon film is preferably 75 GPa or less, and still more preferably 73 GPa or less. The hardness of the hard carbon film is preferably 35 GPa or more and 75 GPa or less, more preferably 45 GPa or more and 73 GPa or less, and still more preferably 55 GPa or more and 73 GPa or less.

The hardness of the hard carbon film can be measured by the nanoindenter method (measurement apparatus: "Nano Indenter XP" (TM) manufactured by MTS). Specifically, the hardness is measured at three locations on the surface of the hard carbon film, and their average value is used as the "hardness". Note that, as far as the applicants performed measurements, even if the hardness measurement results were calculated multiple times by changing the selected locations in the measurement field of view, there was almost no variation in the measurement results, and it was confirmed that the arbitrary setting of the measurement field of view did not result in arbitrary results as long as the measurements were performed on the same sample.

### <Interface Layer>

As shown in Fig. 2, cutting tool 31 of the present embodiment can comprise interface layer 21 disposed between base body 5 and hard carbon film 20. According to this, the base body and the hard carbon film are firmly adhered to each other via the interface layer.

### (Composition)

The composition of interface layer 5 can be as in (K1) or (K2) below.
(K1) Containing at least one selected from the group consisting of a material made of a single element selected from a first group consisting of Group 4 elements, Group 5 elements, Group 6 elements, Group 13 elements, and Group 14 elements excluding carbon in the Periodic Table, an alloy or first compound containing at least one element selected from the first group, and a solid solution derived from the first compound; or
   (K2) Containing one or both of a second compound composed of at least one element selected from the above first group and carbon, and a solid solution derived from the second compound.

That is, the interface layer can be in any of the following forms (k1) to (k4).

(k1) Composed of at least one selected from the group consisting of a material made of a single element selected from the first group, an alloy or first compound containing at least one element selected from the first group, and a solid solution derived from the first compound.

(k2) Containing at least one selected from the group consisting of a material made of a single element selected from the first group, an alloy or first compound containing at least one element selected from the first group, and a solid solution derived from the first compound.

(k3) Composed of one or both of a second compound composed of at least one element selected from the first group and carbon, and a solid solution derived from the second compound.

(k4) Containing one or both of a second compound composed of at least one element selected from the first group and carbon, and a solid solution derived from the second compound.

Here, Group 4 elements in the Periodic Table include, for example, titanium (Ti), zirconium (Zr), and hafnium (Hf). Group 5 elements include, for example, vanadium (V), niobium (Nb), and tantalum (Ta). Group 6 elements include, for example, chromium (Cr), molybdenum (Mo), and tungsten (W). Group 13 elements include, for example, boron (B), aluminum (Al), gallium (Ga), and indium (In). Group 14 elements excluding carbon include, for example, silicon (Si), germanium (Ge), and tin (Sn). Hereinafter, elements included in Group 4 elements, Group 5 elements, Group 6 elements, Group 13 elements, and Group 14 elements excluding carbon are also referred to as the "first elements".

Examples of the alloy containing the first elements include Ti-Zr, Ti-Hf, Ti-V, Ti-Nb, Ti-Ta, Ti-Cr, and Ti-Mo. Examples of the intermetallic compound containing the first elements include TiCr₂ and Ti₃Al.

Examples of the first compound containing the first elements include titanium boride (TiB₂), zirconium boride (ZrB₂), hafnium boride (HfB₂), vanadium boride (VB₂), niobium boride (NbB₂), tantalum boride (TaB₂), chromium boride (CrB), molybdenum boride (MoB), tungsten boride (WB), and aluminum boride (AlB₂).

The above solid solution derived from the first compound means a state in which two or more of these first compounds are dissolved within the crystal structure of each other, meaning an interstitial solid solution or a substitutional solid solution.

Examples of the second compound composed of the first elements and carbon include titanium carbide (TiC), zirconium carbide (ZrC), hafnium carbide (HfC), vanadium carbide (VC), niobium carbide (NbC), tantalum carbide (TaC), chromium carbide (Cr₃C₂), molybdenum carbide (MoC), tungsten carbide (WC), and silicon carbide (SiC).

The above solid solution derived from the second compound means a state in which two or more of these second compounds are dissolved within the crystal structure of each other, meaning an interstitial solid solution or a substitutional solid solution.

The total content ratio of the one a material made of a single element selected from the first group, the alloy or first compound containing at least one selected from the first group, and the solid solution derived from the first compound in the interface layer (hereinafter, also referred to as the "content ratio of the first compound and the like") is preferably 70% or more by volume and 100% or less by volume, more preferably 80% or more by volume and 100% or less by volume, still more preferably 90% or more by volume and 100% or less by volume, and most preferably 100% by volume.

The total content ratio of the second compound and the solid solution derived from the second compound in the interface layer (hereinafter, also referred to as the "content ratio of the second compound and the like") is preferably 70% or more by volume and 100% or less by volume, more preferably 80% or more by volume and 100% or less by volume, still more preferably 90% or more by volume and 100% or less by volume, and most preferably 100% by volume.

The composition of the interface layer, the content ratio of the first compound and the like, and the content ratio of the second compound and the like can be measured by the transmission electron microscopy-energy dispersive X-ray spectrometry (TEM-EDX) method. Specifically, the cutting tool is cut with a FIB (focused ion beam) apparatus to expose the interface layer, and while observing the cross section with a TEM, the composition of the elements constituting the interface layer, the content ratio of the first compound and the like, and the content ratio of the second compound and the like are measured. Note that, as far as the applicants performed measurements, even if the measurement results were calculated multiple times by changing the selected locations in the measurement field of view, there was almost no variation in the measurement results, and it was confirmed that the arbitrary setting of the measurement field of view did not result in arbitrary results as long as the measurements were performed on the same sample.

### (Thickness)

Interface layer 5 preferably has a thickness of 0.1 nm or more and less than 10 nm. When the thickness of the interface layer is in this range, the effect of enhancing the adhesiveness between the base body and the hard carbon film is improved. The thickness of the interface layer is more preferably 0.6 nm or more and 8.0 nm or less, and still more preferably 1.0 nm or more and 5.0 nm or less.

The thickness of the interface layer can be measured by observing the cross section of the hard carbon film using a SEM (scanning electron microscope). Specifically, the observation magnification for the cross section sample is set to 5,000 to 10,000 times, the observation area is set to 100 to 500 µm², the thickness width is measured at three arbitrarily selected locations in one field of view, and their average value is used as the "thickness". Note that, as far as the applicants performed measurements, even if the thickness measurement results were calculated multiple times by changing the selected locations in the measurement field of view, there was almost no variation in the measurement results, and it was confirmed that the arbitrary setting of the measurement field of view did not result in arbitrary results as long as the measurements were performed on the same sample.

### <Other Layer>

The cutting tool of the present embodiment preferably comprises, between the interface layer and the hard carbon film, a mixed composition layer in which the compositions of these films are mixed, or a gradient composition layer in which the composition varies continuously. According to this, the adhesive force between the base body and the hard carbon film is further improved.

It is not always possible to clearly distinguish between the mixed layer and the gradient composition layer. When switching production conditions from the film formation of the interface layer to the film formation of the hard carbon film, there usually occurs a slight mixing of the compositions of the interface layer and the hard carbon film, resulting in formation of the mixed composition layer or gradient composition layer. Although it is difficult to directly confirm the above, their presence can be sufficiently inferred from the results of XPS (X-ray photo-electronic spectroscopy) or AES (Auger electron spectroscopy).

### <Applications of Cutting Tool>

Since the cutting tool of the present embodiment is excellent in wear resistance and deposition resistance, it is particularly suited for processing of aluminum and alloys thereof. It is also suited for processing of non-ferrous materials such as titanium, magnesium, and copper. Furthermore, it is also suited for cutting of materials containing hard particles such as graphite, organic materials, and other materials, as well as for processing of printed circuit boards and simultaneous cutting of ferrous materials and aluminum. In addition, the hard carbon film of the cutting tool of the present embodiment has very high hardness, and therefore can be used for processing of not only non-ferrous materials, but also steels such as stainless steels, casting products, and other materials.

### <Type of Cutting Tool>

The cutting tool of the present embodiment can be, for example, a drill, an end mill, a throw away tip for end milling, a throw away tip for milling, a throw away tip for turning, a metal saw, a gear cutting tool, a reamer, and a tap.

### [Embodiment 2: Method for Manufacturing Cutting Tool]

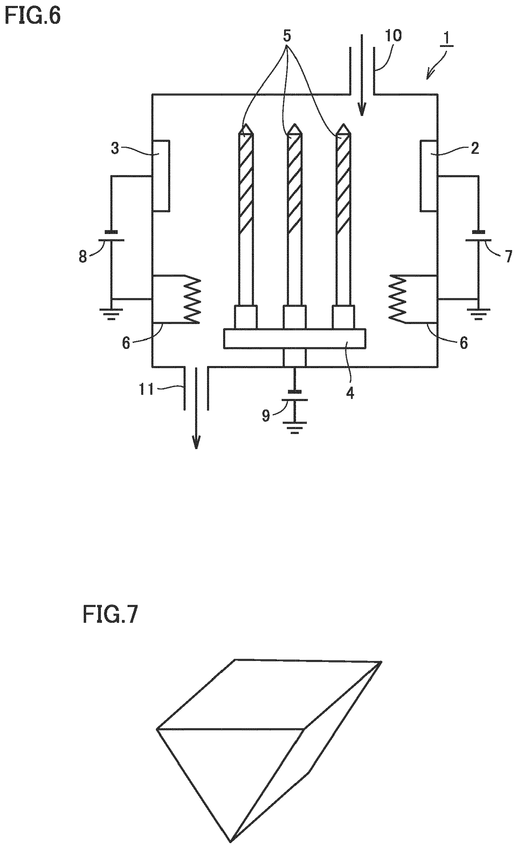

The cutting tool of the present invention can be fabricated by, for example, forming a hard carbon film on a base body using a film forming apparatus 1 shown in Fig. 6. An example of the method for manufacturing the cutting tool of the present invention will be described below.

### (Preparation of Base Body)

Base body 5 is prepared. The type of the base body used can be any of those described in Embodiment 1. For example, the base body is preferably composed of WC-based cemented carbide, cermet, or cubic boron nitride.

Base body 5 is mounted on a base body holder 4 in film forming apparatus 1. Base body holder 4 is rotated between targets around the central point of targets 2 and 3.

While base body 5 is heated to 200°C using a base body heating heater 6, the degree of vacuum in film forming apparatus 1 is set to an atmosphere of 5 × 10⁻⁴ Pa. Subsequently, the set temperature of base body heating heater 6 is lowered and the base body temperature is brought to 100°C, and then argon plasma cleaning is carried out on the surface of the base body by applying a voltage of -1000 V to base body holder 4 with a film forming bias power supply 9 while introducing argon gas and maintaining an atmosphere of 2 × 10⁻¹ Pa. Thereafter, the argon gas is exhausted. In film forming apparatus 1, the gas is supplied through a gas supply port 10, and the gas is discharged through an exhaust port 11.

Next, target 2 composed of a Group 4 element, Group 5 element, or Group 6 element in the Periodic Table is disposed in film forming apparatus 1.

While evaporating and ionizing target 2, a voltage of -600 V is applied to base body holder 4 with bias power supply 9 to carry out metal ion bombardment treatment. As a result, the surface of the base body is etched, improving the adhesiveness of the interface layer and hard carbon film that will be formed later.

Note that the formation of the interface layer and formation of the hard carbon film, which will be mentioned later, may be carried out without carrying out the metal ion bombardment treatment on the base body.

### (Formation of Interface Layer)

Next, target 2 composed of one element selected from Group 4 elements, Group 5 elements, Group 6 elements, Group 13 elements, and Group 14 elements excluding carbon in the Periodic Table is disposed in film forming apparatus 1. The target 2 is evaporated and ionized by vacuum arc discharge while introducing or not introducing hydrocarbon gas, and a voltage of -100 V to -800 V is applied to base body holder 4 with bias power supply 9 to form the interface layer on the base body. Thereafter, the hydrocarbon gas is exhausted.

Note that the formation of the hard carbon film, which will be mentioned later, may be carried out without forming the interface layer on the base body.

### (Formation of Hard Carbon Film)

Next, target 3 composed of glassy carbon is disposed in film forming apparatus 1. While introducing argon gas at a flow rate of 15 cc/min, target 3 is evaporated and ionized by vacuum arc discharge (cathode current 120 A), and a voltage of -100 V is applied to base body holder 4 with bias power supply 9 to form the hard carbon film on the interface layer, thereby obtaining the cutting tool. Hydrocarbon gas may be introduced along with argon gas. The temperature of base body heating heater 6 during the film formation is set to 180°C.

As the glassy carbon, those commercially available can be used. Glassy carbon is a highly pure carbonaceous material and is free from contamination by metallic elements compared to sintered carbon (such as sintered graphite) used in conventional cathodes. In particular, glassy carbon manufactured by Hitachi Chemical Co., Ltd. does not contain aluminum (Al) and is therefore particularly suitable for cutting of aluminum alloys. Also, when glassy carbon is used, generation of macroparticles in the hard carbon film can be suppressed and a smooth hard carbon film can be obtained, improving cutting performance.

The shape of the target used is generally cylindrical, disk-shaped, or rectangular. However, as a result of diligent investigations, the present inventors have newly found that a triangular prism shape, as shown in Fig. 7, is suitable from the viewpoint of improving the film quality of the hard carbon film. To the target, a high current needs to be applied, and the use of a V-shaped electrode and adhesion between the side of the target and the electrode enables a stable power supply to the target. Furthermore, because the target and the electrode adhere to each other, the cooling effect can also be enhanced. Efficient cooling of the target lowers electrical resistance and facilitates arc spot migration. As a result, occurrence of defects in the hard carbon film is suppressed and the film quality of the hard carbon film is improved.

From the viewpoint of improving the purity of the hard carbon film, film formation in a vacuum without introducing Ar gas is preferred. However, as a result of diligent investigations, the present inventors have newly found that arc discharge is more stable and film quality is improved when Ar gas is supplied at a flow rate of 15 cc/min rather than in a vacuum.

### Examples

The present embodiments will be described even further specifically by way of Examples. However, the present embodiments shall not be limited by these Examples.

### «Example 1»

### [Fabrication of Cutting Tool]

### «Sample 1 to Sample 3»

In Sample 1 to Sample 3, cutting tools were fabricated by using glassy carbon as a raw material and forming the hard carbon film on the base body using the cathodic arc ion plating method (referred to as "Arc method" in Table 1).

### (Preparation of Base Body)

A φ6 mm drill made of WC (particle size: 1 µm) based cemented carbide was prepared as the base body. This base body contains 8% by mass of Co as the binder.

The base body was mounted inside film forming apparatus 1 shown in Fig. 6, and while heating the base body to 200°C using base body heating heater 6, the degree of vacuum in film forming apparatus 1 was set to an atmosphere of 5 × 10⁻⁴ Pa. Subsequently, the set temperature of base body heating heater 6 was lowered and the base body temperature was brought to 100°C, and then argon plasma cleaning was carried out on the surface of the base body by applying a voltage of -1000 V to base body holder 4 with film forming bias power supply 9 while introducing argon gas and maintaining an atmosphere of 2 × 10⁻¹ Pa. Thereafter, the argon gas was exhausted.

### (Formation of Hard Carbon Film)

Next, while introducing argon gas into film forming apparatus 1 at a flow rate of 15 cc/min, a triangular prism-shaped target made of glassy carbon ("Glass-like Carbon" manufactured by Hitachi Chemical Co., Ltd.) was evaporated and ionized by vacuum arc discharge (cathode current 120 A), and a voltage of -100 V was applied to base body holder 4 with bias power supply 9 to form the hard carbon film on the base body, thereby obtaining the cutting tool. The temperature of base body heating heater 6 during the film formation of the hard carbon film was set to 180°C. The thickness of the hard carbon film for each sample is as shown in the "Thickness (µm)" column under "Hard carbon film" in Table 1.

### «Sample 4 to Sample 7»

In Sample 4 to Sample 7, cutting tools were fabricated by forming the interface layer and the hard carbon film on the base body in this order using the cathodic arc ion plating method.

### <Sample 4>

### (Preparation of Base Body)

The base body was prepared by the same method as in Sample 1.

### (Formation of Interface Layer)

Next, while introducing hydrocarbon gas into film forming apparatus 1 at a flow rate of 15 cc/min, a triangular prism-shaped target made of chromium (Cr) was evaporated and ionized by vacuum arc discharge (cathode current 80 A), and a voltage of -100 V was applied to base body holder 4 with bias power supply 9 to form the interface layer composed of chromium carbide (CrC) with a thickness of 5 nm on the base body. Thereafter, the hydrocarbon gas was exhausted.

### (Formation of Hard Carbon Film)

Next, while introducing argon gas and hydrocarbon gas into film forming apparatus 1 at a flow rate of 15 cc/min and 5 cc/min, respectively, a triangular prism-shaped target made of glassy carbon ("Glass-like Carbon" manufactured by Hitachi Chemical Co., Ltd.) was evaporated and ionized by vacuum arc discharge (cathode current 120 A), and a voltage of -100 V was applied to base body holder 4 with bias power supply 9 to form the hard carbon film with a thickness of 0.6 µm on the interface layer, thereby obtaining the cutting tool. The temperature of base body heating heater 6 during the film formation of the hard carbon film was set to 180°C.

### <Sample 5>

### (Preparation of Base Body)

The base body was prepared by the same method as in Sample 1.

### (Formation of Interface Layer)

Next, without introducing gas into film forming apparatus 1, a target made of chromium (Cr) was evaporated and ionized by vacuum arc discharge (cathode current 80 A), and a voltage of -800 V was applied to base body holder 4 with bias power supply 9 to form the interface layer composed of chromium (Cr) with a thickness of 5 nm on the base body.

### (Formation of Hard Carbon Film)

Next, while introducing argon gas and hydrocarbon gas into film forming apparatus 1 at a flow rate of 15 cc/min and 20 cc/min, respectively, a triangular prism-shaped target made of glassy carbon ("Glass-like Carbon" manufactured by Hitachi Chemical Co., Ltd.) was evaporated and ionized by vacuum arc discharge (cathode current 120 A), and a voltage of -100 V was applied to base body holder 4 with bias power supply 9 to form the hard carbon film with a thickness of 0.4 µm on the interface layer, thereby obtaining the cutting tool. The temperature of base body heating heater 6 during the film formation of the hard carbon film was set to 180°C.

### <Sample 6>

### (Preparation of Base Body)

The base body was prepared by the same method as in Sample 1.

### (Formation of Interface Layer)

Next, while introducing hydrocarbon gas into film forming apparatus 1 at a flow rate of 15 cc/min, a triangular prism-shaped target made of titanium (Ti) was evaporated and ionized by vacuum arc discharge (cathode current 80 A), and a voltage of -100 V was applied to base body holder 4 with bias power supply 9 to form the interface layer composed of titanium carbide (TiC) with a thickness of 5 nm on the base body. Thereafter, the hydrocarbon gas was exhausted.

### (Formation of Hard Carbon Film)

Next, while introducing argon gas into film forming apparatus 1 at a flow rate of 15 cc/min, a triangular prism-shaped target made of glassy carbon ("Glass-like Carbon" manufactured by Hitachi Chemical Co., Ltd.) was evaporated and ionized by vacuum arc discharge (cathode current 120 A), and a voltage of -100 V was applied to base body holder 4 with bias power supply 9 to form the hard carbon film with a thickness of 0.6 µm on the interface layer, thereby obtaining the cutting tool. The temperature of base body heating heater 6 during the film formation of the hard carbon film was set to 180°C.

### <Sample 7>

### (Preparation of Base Body)

The base body was prepared by the same method as in Sample 1.

### (Formation of Interface Layer)

Next, without introducing gas into film forming apparatus 1, a target made of titanium (Ti) was evaporated and ionized by vacuum arc discharge (cathode current 80 A), and a voltage of -100 V was applied to base body holder 4 with bias power supply 9 to form the interface layer composed of titanium (Ti) with a thickness of 5 nm on the base body.

### (Formation of Hard Carbon Film)

Next, while introducing argon gas into film forming apparatus 1 at a flow rate of 15 cc/min, a triangular prism-shaped target made of glassy carbon ("Glass-like Carbon" manufactured by Hitachi Chemical Co., Ltd.) was evaporated and ionized by vacuum arc discharge (cathode current 120 A), and a voltage of -100 V was applied to base body holder 4 with bias power supply 9 to form the hard carbon film with a thickness of 0.9 µm on the interface layer, thereby obtaining the cutting tool. The temperature of base body heating heater 6 during the film formation of the hard carbon film was set to 180°C.

### <<Sample 8 to Sample 11>>

In Sample 8 to Sample 11, cutting tools were fabricated by using sintered graphite as a raw material and forming the hard carbon film on the base body using the cathodic arc ion plating method.

### (Preparation of Base Body)

The base body was prepared by the same method as in Sample 1.

### (Formation of Hard Carbon Film)

Next, while introducing into film forming apparatus 1 argon gas at a flow rate of 15 cc/min (Samples 8, 10, and 11) or argon gas and hydrocarbon gas at a flow rate of 15 cc/min and 5 cc/min (Sample 9), respectively, a triangular prism-shaped target made of sintered graphite ("IG-510" manufactured by Toyo Tanso Co., Ltd.) was evaporated and ionized by vacuum arc discharge (cathode current 180 A for Sample 8, 120 A for Samples 9 and 10, and 150 A for Sample 11), and a voltage of -100 V was applied to base body holder 4 with bias power supply 9 to form the hard carbon films with a thickness of 0.5 µm on the base body, thereby obtaining the cutting tools. The temperature of base body heating heater 6 during the film formation of the hard carbon film was set to 180°C.

### «Sample 12»

In Sample 12, a cutting tool was fabricated by forming the hard carbon film with a thickness of 0.5 µm on the same base body as Sample 1, using a plasma CVD method with methane gas as the raw material.

### [Evaluation]

### (Measurement of Area Proportion of Black Regions)

The area proportion of black regions was measured for the hard carbon film of each sample. The method for measuring the area proportion of black regions is described in Embodiment 1, and thus the description therefor will not be repeated. The results are shown in the "Area proportion of black regions (%)" column of Table 1.

### (Measurement of Hydrogen Content)

The hydrogen content was measured for the hard carbon film of each sample. The method for measuring the hydrogen content is described in Embodiment 1, and thus the description therefor will not be repeated. The results are shown in the "Hydrogen content (atom%)" column of Table 1.

### (Measurement of Hardness)

The hardness was measured for the hard carbon film of each sample. The method for measuring the hardness is described in Embodiment 1, and thus the description therefor will not be repeated. The results are shown in the "Hardness (GPa)" column of Table 1.

### (Cutting Test)

Using the cutting tool of each sample, drilling was carried out under the following cutting conditions.
Work material: ADC12 (Al-Si-Cu alloy)
Cutting speed: 200 m/min
Feed speed: 0.4 mm/rev
Hole depth: 23 mm stop
Coolant: internal oil supply 1.9 MPa

The number of holes drilled until the tip of the drill was worn out, the adherence of the aluminum alloy occurred, and then defects (500 µm or more) occurred was measured. The larger the number of drilled holes, the better the wear resistance and the longer the tool life. The results are shown in the "Number of drilled holes" column under "Cutting test" in Table 1.

### [Table 1]

**Table 1**

| Sample No. | Film formation method | Target | Film formation conditions of hard carbon film | | | | Interface layer | Hard carbon film | | | | Cutting test |
|---|---|---|---|---|---|---|---|---|---|---|---|---|
| | | | Argon gas flow rate (cc/min) | Hydrocarbon gas flow rate (cc/min) | Cathode current (A) | Bias voltage (V) | Type: Thickness | Area proportion of black regions (%) | Thickness (µm) | Hydrogen content (atom%) | Hardness (GPa) | Number of drilled holes |
| 1 | Arc method | Glassy carbon | 15 | Absent | 120 | -100 | Absent | 0.7 | 0.4 | 0.2 | 73 | 4300 |
| 2 | Arc method | Glassy carbon | 15 | Absent | 120 | -100 | Absent | 0.5 | 1.5 | 0.3 | 69 | 6500 |
| 3 | Arc method | Glassy carbon | 15 | Absent | 120 | -100 | Absent | 0.2 | 2.9 | 02 | 70 | 12000 |
| 4 | Arc method | Glassy carbon | 15 | 5 | 120 | -100 | CrC:5nm | 0.3 | 0.6 | 1.1 | 52 | 5500 |
| 5 | Arc method | Glassy carbon | 15 | 20 | 120 | -100 | Cr 5nm | 0.1 | 0.4 | 5.0 | 51 | 5300 |
| 6 | Arc method | Glassy carbon | 15 | Absent | 120 | -100 | TiC:5nm | 0.1 | 0.6 | 0.6 | 55 | 6400 |
| 7 | Arc method | Glassy carbon | 15 | Absent | 120 | -100 | Ti:5nm | 0.4 | 0.9 | 0.2 | 71 | 8000 |
| 8 | Arc method | Sintered graphite | 15 | Absent | 180 | -100 | Absent | 5.4 | 0.5 | 0.5 | 64 | 2000 |
| 9 | Arc method | Sintered graphite | 15 | 5 | 120 | -100 | Absent | 1.2 | 0.5 | 1.5 | 48 | 1800 |
| 10 | Arc method | Sintered graphite | 15 | Absent | 120 | -100 | Absent | 0.9 | 0.5 | 0.5 | 66 | 3200 |
| 11 | Arc method | Sintered graphite | 15 | Absent | 150 | -100 | Absent | 3.8 | 0.5 | 0.7 | 50 | 1200 |
| 12 | CVD method | (Methane gas) | - | - | - | - | Absent | 0.3 | 0.5 | 23 | 22 | 300 |

### <Discussion>

The cutting tools of Sample 1 to Sample 7 correspond to Examples. The cutting tools of Sample 8 to Sample 12 correspond to Comparative Examples.

It was confirmed that Sample 1 to Sample 7 (Examples) had a larger number of drilled holes, superior wear resistance, and a longer tool life compared to Sample 8 to Sample 12 (Comparative Examples). Note that, in Sample 1 to Sample 3 and Samples 6 and 7, the film formation conditions for the hard carbon films are the same, but the area proportions of black regions are different. This is thought to be a variation in production.

Sample 8 to Sample 11 have hard carbon films with area proportions of black regions of greater than 0.7% and with degrees of crystallinity of greater than 6.5%, and thus are considered to have a low hardness, decreased wear resistance, and a short tool life.

Sample 12 has a hard carbon film with a hydrogen content of greater than 5 atom%, and thus is considered to have a low hardness, decreased wear resistance, and a short tool life.

«Example 2»

### «Sample 2-1»

### (Preparation of Base Body)

An insert made of cermet with a chip model number of DCGT11T308N-AG was prepared as the base body. Argon plasma cleaning was carried out on the base body surface in the same manner as for Sample 1.

### (Formation of Hard Carbon Film)

Next, the hard carbon film with a thickness of 0.4 µm was formed on the base body by film formation under the same conditions as for Sample 1, thereby obtaining a cutting tool.

### «Sample 2-2»

Sample 2-2 is the same insert as the one made of cermet that was prepared for Sample 2-1. Sample 2-2 has no hard carbon film.

### [Evaluation]

### (Measurement of Area Proportion of Black Regions, Measurement of Hydrogen Content, and Measurement of Hardness)

For the hard carbon film of Sample 2-1, measurement of the area proportion of black regions, measurement of the hydrogen content, and measurement of the hardness were carried out. Each measurement method is described in Embodiment 1, and thus the description therefor will not be repeated. The results are shown in the "Area proportion of black regions (%)", "Hydrogen content (atom%)", and "Hardness (GPa)" columns of Table 2.

### (Cutting Test)

Using the cutting tool of each sample, round bar turning was carried out under the following cutting conditions.
Work material: ADC12 (Al-Si-Cu alloy) round bar
Cutting speed: 300 m/min
Feed speed: 0.2 mm/rev
Cut depth: 2.0 mm
Cutting oil: DRY

The cutting length (km) was measured until defects (500 µm or more) occurred in the tool due to cutting edge adherence. The longer the cutting length, the better the defect resistance and the longer the tool life. The results are shown in the "Cutting length" column under "Cutting test" in Table 2.

### [Table 2]

**Table 2**

| Sampl e No. | Presence/absenc e of film | Film formatio n method | Target | Interface layer | Hard carbon film | | | | Cuttin g test |
|---|---|---|---|---|---|---|---|---|---|
| | | | | Type: Thicknes s | Area proportio n of black regions (%) | Thicknes s (µm) | Hydroge n content (atom%) | Hardnes s (GPa) | Cuttin g length (km) |
| 2-1 | Present | Arc method | Glass y carbo n | Absent | 0.7 | 0.4 | 0.2 | 73 | 1.1 |
| 2-2 | Absent | - | - | - | - | - | - | - | 0.6 |

### <Discussion>

The cutting tool of Sample 2-1 corresponds to Example. The cutting tool of Sample 2-2 corresponds to Comparative Example. It was confirmed that Sample 2-1 (Example) had a longer cutting length, superior defect resistance, and a longer tool life compared to Sample 2-2 (Comparative Example).

### «Example 3»

### «Sample 3-1»

### (Preparation of Base Body)

An insert made of cubic boron nitride with a chip model number of VBGW160408 was prepared as the base body. Argon plasma cleaning was carried out on the base body surface in the same manner as for Sample 1.

### (Formation of Hard Carbon Film)

Next, the hard carbon film with a thickness of 0.4 µm was formed on the base body by film formation under the same conditions as for Sample 1, thereby obtaining a cutting tool.

### «Sample 3-2»

Sample 3-2 is the same insert as the one made of cubic boron nitride that was prepared for Sample 3-1. Sample 3-2 has no hard carbon film.

### [Evaluation]

### (Measurement of Area Proportion of Black Regions, Measurement of Hydrogen Content, and Measurement of Hardness)

For the hard carbon film of Sample 3-1, measurement of the area proportion of black regions, measurement of the hydrogen content, and measurement of the hardness were carried out. Each measurement method is described in Embodiment 1, and thus the description therefor will not be repeated. The results are shown in the "Area proportion of black regions (%)", "Hydrogen content (atom%)", and "Hardness (GPa)" columns of Table 3.

### (Cutting Test)

Using the cutting tool of each sample, round bar turning was carried out under the following cutting conditions.
Work material: ADC12 (Al-Si-Cu alloy) round bar
Cutting speed: 400 m/min
Feed speed: 0.05 mm/rev
Cut depth: 2.0 mm
Cutting oil: WET

The cutting length (km) was measured until defects (500 µm or more) occurred in the tool due to cutting edge adherence. The longer the cutting length, the better the defect resistance and the longer the tool life. The results are shown in the "Cutting length" column under "Cutting test" in Table 3.

### [Table 3]

**Table 3**

| Sampl e No. | Presence/absenc e of film | Film formatio n method | Target | Interface layer | Hard carbon film | | | | Hard carbon film |
|---|---|---|---|---|---|---|---|---|---|
| | | | | Type: Thicknes s | Area proportio n of black regions (%) | Thicknes s (µm) | Hydroge n content (atom%) | Hardnes s (GPa) | Cuttin g length (km) |
| 3-1 | Present | Arc method | Glass y carbo n | Absent | 0.7 | 0.4 | 0.2 | 73 | 30 |
| 3-2 | Absent | - | - | - | - | - | - | - | 25 |

### <Discussion>

The cutting tool of Sample 3-1 corresponds to Example. The cutting tool of Sample 3-2 corresponds to Comparative Example. It was confirmed that Sample 3-1 (Example) had a longer cutting length, superior defect resistance, and a longer tool life compared to Sample 3-2 (Comparative Example).

While the above description of the embodiments and Examples of the present invention has been given, it has been planned from the outset to combine the configuration of each of the above-mentioned embodiments and Examples as appropriate, or to modify them in various ways.

### REFERENCE SIGNS LIST

1 film forming apparatus; 2, 3 target; 4 base body holder; 5 base body; 6 base body heating heater; 7, 8 power supply; 9 film forming bias power supply; 10 gas supply port; 11 exhaust port; 20 hard carbon film; 21 interface layer; 30, 31 cutting tool; a, b, c, d line segment; B black region; S 1 principal plane of base body; S2 surface of hard carbon film

## Claims

1. A cutting tool comprising a base body and a hard carbon film arranged on the base body, wherein
when a cross section of the hard carbon film is observed using a high angle annular dark field scanning transmission electron microscope, an area proportion of black regions with an equivalent circle diameter of 10 nm or more is 0.7% or less, the area proportion of black regions being measured using the method described in the description,
the hard carbon film is amorphous,
the carbon content of the hard carbon film is 95 atom% or more, and
the hard carbon film has a hydrogen content of 5 atom% or less.

2. The cutting tool according to claim 1, wherein the area proportion of black regions is 0% or more and 0.5% or less.

3. The cutting tool according to claim 2, wherein the area proportion of black regions is 0% or more and 0.3% or less.

4. The cutting tool according to any one of claims 1 to 3, wherein the hard carbon film has a hydrogen content of 0 atom% or more and 4 atom% or less.

5. The cutting tool according to claim 4, wherein the hard carbon film has a hydrogen content of 0 atom% or more and 2 atom% or less.

6. The cutting tool according to any one of claims 1 to 5, wherein the hard carbon film has a thickness of 0.1 µm or more and 3 µm or less at a portion involved in cutting.

7. The cutting tool according to any one of claims 1 to 6, wherein the base body and the hard carbon film are in contact with each other.

8. The cutting tool according to any one of claims 1 to 6, comprising an interface layer disposed between the base body and the hard carbon film,
wherein the interface layer contains:
at least one selected from the group consisting of a material made of a single element selected from a first group consisting of Group 4 elements, Group 5 elements, Group 6 elements, Group 13 elements, and Group 14 elements excluding carbon in the Periodic Table, an alloy containing at least one element selected from the first group, first compound containing at least one element selected from the first group, and a solid solution derived from the first compound; or
one or both of a second compound composed of at least one element selected from the first group and carbon, and a solid solution derived from the second compound, and
the interface layer has a thickness of 0.5 nm or more and less than 10 nm.

9. The cutting tool according to any one of claims 1 to 8, wherein the hard carbon film has a hardness of 35 GPa or more and 75 GPa or less and the hardness is measured by the nanoindenter method.

10. The cutting tool according to claim 9, wherein the hard carbon film has a hardness of 45 GPa or more and 73 GPa or less.

11. The cutting tool according to any one of claims 1 to 10, wherein the base body is composed of WC-based cemented carbide or cermet.

12. The cutting tool according to any one of claims 1 to 10, wherein the base body is composed of cubic boron nitride.

## Patentansprüche

1. Schneidwerkzeug, umfassend einen Grundkörper und einen auf dem Grundkörper angeordneten Hartkohlenstofffilm, wobei
bei der Betrachtung eines Querschnitts der Hartkohlenstofffilm mit einem Hochwinkel-Ring-Dunkelfeld-Rastertransmissionselektronenmikroskop ein Flächenanteil schwarzer Bereiche mit einem äquivalenten Kreisdurchmesser von 10 nm oder mehr 0,7 % oder weniger beträgt und der Flächenanteil schwarzer Bereiche nach dem in der Beschreibung beschriebenen Verfahren gemessen wird,
der Hartkohlenstofffilm amorph ist,
der Kohlenstoffgehalt des Hartkohlenstofffilms 95 Atom-% oder mehr beträgt und der Hartkohlenstofffilm einen Wasserstoffgehalt von 5 Atom-% oder weniger aufweist.

2. Schneidwerkzeug nach Anspruch 1, bei dem der Flächenanteil der schwarzen Bereiche 0 % oder mehr und 0,5 % oder weniger beträgt.

3. Schneidwerkzeug nach Anspruch 2, bei dem der Flächenanteil der schwarzen Bereiche 0 % oder mehr und 0,3 % oder weniger beträgt.

4. Schneidwerkzeug nach einem der Ansprüche 1 bis 3, bei dem der Hartkohlenstofffilm einen Wasserstoffgehalt von 0 Atom% oder mehr und 4 Atom% oder weniger aufweist.

5. Schneidwerkzeug nach Anspruch 4, bei dem der Hartkohlenstoffilm einen Wasserstoffgehalt von 0 Atom% oder mehr und 2 Atom% oder weniger aufweist.

6. Schneidwerkzeug nach einem der Ansprüche 1 bis 5, bei dem der Hartkohlenstofffilm eine Dicke von 0,1 µm oder mehr und 3 µm oder weniger an einem beim Schneiden beteiligten Abschnitt aufweist.

7. Schneidwerkzeug nach einem der Ansprüche 1 bis 6, bei dem der Grundkörper und der Hartkohlenstoffilm miteinander in Kontakt sind.

8. Schneidwerkzeug nach einem der Ansprüche 1 bis 6, umfassend eine Grenzschicht, die zwischen dem Grundkörper und dem Hartkohlenstofffilm angeordnet ist, wobei die Grenzschicht umfasst:
wenigstens ein Element, das aus der Gruppe ausgewählt ist, bestehend aus einem Material, das aus einem einzelnen Element hergestellt ist, das aus einer ersten Gruppe ausgewählt ist, die aus Elementen der Gruppe 4, Elementen der Gruppe 5, Elementen der Gruppe 6, Elementen der Gruppe 13 und Elementen der Gruppe 14 des Periodensystems mit Ausnahme von Kohlenstoff besteht, einer Legierung, die wenigstens ein Element enthält, das aus der ersten Gruppe ausgewählt ist, einer ersten Verbindung, die wenigstens ein Element enthält, das aus der ersten Gruppe ausgewählt ist, und einer festen Lösung, die von der ersten Verbindung abgeleitet ist; oder
eine zweite Verbindung, die aus einem Element aus der ersten Gruppe und Kohlenstoff und/oder einer festen Lösung, die aus der zweiten Verbindung abgeleitet ist, besteht, und
die Grenzschicht eine Dicke von 0,5 nm oder mehr und weniger als 10 nm hat.

9. Schneidwerkzeug nach einem der Ansprüche 1 bis 8, bei dem die harte Kohlenstoffschicht eine Härte von 35 GPa oder mehr und 75 GPa oder weniger aufweist und die Härte mit dem Nanoindenter-Verfahren gemessen wird.

10. Schneidwerkzeug nach Anspruch 9, bei dem die harte Kohlenstoffschicht eine Härte von 45 GPa oder mehr und 73 GPa oder weniger aufweist.

11. Schneidwerkzeug nach einem der Ansprüche 1 bis 10, bei dem der Grundkörper aus Sinterkarbid oder Cermet auf WC-Basis besteht.

12. Schneidwerkzeug nach einem der Ansprüche 1 bis 10, bei dem der Grundkörper aus kubischem Bornitrid besteht.

## Revendications

1. Outil de coupe comprenant un corps de base et un film de carbone dur disposé sur le corps de base, dans lequel
lorsqu'une section transversale du film de carbone dur est observée à l'aide d'un microscope électronique à transmission à balayage à champ sombre annulaire à grand angle, une proportion en aire de régions noires ayant un diamètre de cercle équivalent supérieur ou égal à 10 nm est inférieure ou égale à 0,7 %, la proportion en aire de régions noires étant mesurée selon le procédé décrit dans la description,
le film de carbone dur est amorphe,
la teneur en carbone du film de carbone dur est supérieure ou égale à 95 % atomiques, et
le film de carbone dur a une teneur en hydrogène inférieure ou égale à 5 % atomiques.

2. Outil de coupe selon la revendication 1, dans lequel la proportion en aire de régions noires est supérieure ou égale à 0 % et inférieure ou égale à 0,5 %.

3. Outil de coupe selon la revendication 2, dans lequel la proportion en aire de régions noires est supérieure ou égale à 0 % et inférieure ou égale à 0,3 %.

4. Outil de coupe selon l'une quelconque des revendications 1 à 3, dans lequel le film de carbone dur a une teneur en hydrogène supérieure ou égale à 0 % atomique et inférieure ou égale à 4 % atomiques.

5. Outil de coupe selon la revendication 4, dans lequel le film de carbone dur a une teneur en hydrogène supérieure ou égale à 0 % atomique et inférieure ou égale à 2 % atomiques.

6. Outil de coupe selon l'une quelconque des revendications 1 à 5, dans lequel le film de carbone dur a une épaisseur supérieure ou égale à 0,1 µm et inférieure ou égale à 3 µm au niveau d'une partie impliquée dans la coupe.

7. Outil de coupe selon l'une quelconque des revendications 1 à 6, dans lequel le corps de base et le film de carbone dur sont en contact l'un avec l'autre.

8. Outil de coupe selon l'une quelconque des revendications 1 à 6, comprenant une couche d'interface disposée entre le corps de base et le film de carbone dur,
dans lequel la couche d'interface contient :
au moins l'un choisi dans le groupe constitué d'un matériau constitué d'un élément unique choisi dans un premier groupe constitué des éléments du groupe 4, des éléments du groupe 5, des éléments du groupe 6, des éléments du groupe 13 et des éléments du groupe 14 à l'exclusion du carbone dans la table périodique, un alliage contenant au moins un élément choisi dans le premier groupe, un premier composé contenant au moins un élément choisi dans le premier groupe, et une solution solide dérivée du premier composé ; ou
l'un ou les deux parmi un deuxième composé constitué d'au moins un élément choisi parmi le premier groupe et le carbone, et une solution solide dérivée du deuxième composé, et
la couche d'interface a une épaisseur supérieure ou égale à 0,5 nm et inférieure à 10 nm.

9. Outil de coupe selon l'une quelconque des revendications 1 à 8, dans lequel le film de carbone dur a une dureté supérieure ou égale à 35 GPa et inférieure ou égale à 75 GPa et la dureté est mesurée par la méthode du nano-indenteur.

10. Outil de coupe selon la revendication 9, dans lequel le film de carbone dur a une dureté supérieure ou égale à 45 GPa et inférieure ou égale à 73 GPa.

11. Outil de coupe selon l'une quelconque des revendications 1 à 10, dans lequel le corps de base est composé de carbure cémenté ou de cermet à base de WC.

12. Outil de coupe selon l'une quelconque des revendications 1 à 10, dans lequel le corps de base est composé de nitrure de bore cubique.
